# EUROPEAN PATENT APPLICATION

(11) **EP 4 279 561 A1**
(43) Date of publication of application: **22.11.2023**
(21) Application number: 22739420.2
(22) Date of filing: 12.01.2022
(51) Int. Cl.: C09K 3/14, H01L 21/304

(54) **POLISHING COMPOSITION**

(30) Priority: 18.01.2021 JP 2021005835
(71) Applicant: Fujimi Incorporated, Kiyosu-shi, Aichi 452-8502 (JP)
(72) Inventor: TANABE, Yoshiyuki, Kiyosu-shi, Aichi 452-8502 (JP); TANIGUCHI, Megumi, Kiyosu-shi, Aichi 452-8502 (JP); TSUCHIYA, Kohsuke, Kiyosu-shi, Aichi 452-8502 (JP)
(74) Representative: Grünecker Patent- und Rechtsanwälte PartG mbB
(86) International application number: PCT/JP2022/000755
(87) International publication number: WO 2022/154015

(57) **Abstract**

Provided is a polishing composition that can achieve the suppression of reduction in the polishing removal rate and the reduction in the amount of edge roll-off after polishing, both at high levels. A polishing composition to be used for stock polishing of a silicon wafer is provided. The polishing composition consists of an abrasive, a basic compound, a surfactant, a chelating agent, and water, wherein the surfactant contains a surfactant I having a repeating structure of oxyalkylene units.

## Description

### [Technical Field]

The present invention relates to a polishing composition. More specifically, the invention relates to a polishing composition for performing stock polishing on silicon wafers. This application claims priority to Japanese Patent Application No. 2021-5835 filed on 18 January 2021; and the entire content thereof is herein incorporated by reference.

### [Background Art]

Silicon wafers, which are used to manufacture semiconductor products, generally have their surfaces finished to a high quality mirror finish through a lapping step (rough polishing step) and a polishing step (precision polishing step). The above-mentioned polishing step typically includes a stock polishing step and a final polishing step. Patent Documents 1 and 2 are given as examples of technical documents relating to polishing compositions usable for the polishing of silicon wafers and the like.

### [Citation List]

### [Patent Literature]

[Patent Document 1] WO2018/180479
[Patent Document 2] Japanese Patent Application Publication No. 2016-124943

### [Summary of Invention]

### [Technical Problem]

In general, the stock polishing step is thought as a process for efficiently preparing the shape and rough surface condition of a silicon wafer by removing a part of the silicon wafer surface using a polishing slurry with a relatively high processibility. Such a stock polishing step is required to be performed with excellent polishing performance (specifically, high polishing removal rate, or the like).

In order to improve the polishing removal rate, it is known to add a basic compound in a polishing composition used for polishing a silicon wafer or the like. However, in a conventional method for improving the polishing removal rate using the basic compound, an outer peripheral portion, i.e., near the edge, of the silicon wafer is excessively polished compared to its center, which may cause an undesired decrease in the thickness of the outer peripheral portion after the polishing (edge roll-off). Patent Documents 1 and 2 propose the use of specific kinds of water-soluble polymers to suppress edge roll-off, but there is a further need to achieve both a high polishing removal rate which is suitable for the stock polishing step and the reduction in the edge roll-off.

Therefore, the present invention has an object to provide a polishing composition for a stock polishing step of silicon wafers that can achieve the suppression of reduction in the polishing removal rate and the reduction in the amount of edge roll-off after polishing, both at high levels.

### [Solution to Problem]

According to the present specification, a polishing composition to be used for stock polishing of a silicon wafer is provided. The polishing composition consists of an abrasive, a basic compound, a surfactant, a chelating agent, and water. The surfactant contains a surfactant I having a repeating structure of oxyalkylene units. According to such an embodiment, the reduction in the amount of edge roll-off after polishing can be achieved while suppressing the reduction in the polishing removal rate.

In a preferred embodiment of the polishing composition disclosed herein, the surfactant I is a polyoxyalkylene alkyl ether. The inclusion of polyoxyalkylene alkyl ether as the surfactant can reduce more effectively the amount of edge roll-off after polishing.

In a preferred embodiment of the polishing composition disclosed herein, a ratio (B/S) of a content (B) of the basic compound by weight to a content (S) of the surfactant I by weight is 50 or more. According to such an embodiment, the reduction in the amount of edge roll-off after polishing can be achieved more effectively while maintaining the polishing removal rate.

In a preferred embodiment of the polishing composition disclosed herein, a ratio (A/S) of a content (A) of the abrasive by weight to a content (S) of the surfactant I by weight is less than 1000. According to such an embodiment, the reduction in the amount of edge roll-off after polishing can be achieved more effectively while maintaining the polishing removal rate.

In a preferred embodiment of the polishing composition disclosed herein, the abrasive contains silica particles. In an embodiment of using silica particles as the abrasive, the reduction in the amount of edge roll-off after polishing can be achieved more effectively.

### [Description of Embodiments]

Preferred embodiments of the present invention will be described below. Incidentally, matters that are other than those particularly mentioned in the present specification but are necessary for implementation of the present invention can be recognized by those skilled in the art as design matters based on the prior art in the relevant field. The present invention can be implemented based on contents disclosed in the present specification and common general technical knowledge in the field.

### <Abrasive>

The polishing composition disclosed herein contains an abrasive. The material and properties of the abrasive are not particularly limited, and can be selected as appropriate in view of the use mode or the like of the polishing composition. Examples of abrasives include inorganic particles, organic particles and organic-inorganic composite particles. Specific examples of inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and colcothar particles; nitride particles such as silicon nitride particles and boron nitride particles; carbide particles such as silicon carbide particles and boron carbide particles; diamond particles; and carbonates such as calcium carbonate and barium carbonate. Specific examples of organic particles include polymethyl methacrylate (PMMA) particles, poly(meth)acrylic acid particles, polyacrylonitrile particles, and the like. Here, (meth)acrylic acid encompasses both acrylic acid and methacrylic acid. These abrasives can be used alone or in combination with two or more kinds.

As the abrasive, inorganic particles are preferable. Of these, particles formed of an oxide of metal or of metalloid are preferable. Preferred examples of the abrasive usable in the art disclosed herein include silica particles. The reason for this is as follows. In the polishing where an object to be polished is a silicon wafer, if silica particles composed of oxygen atoms and an element that is the same as the object to be polished are used as the abrasives, no residues of metals or mettaloids different from silicon are produced after polishing. As a result, there are no concerns regarding a deterioration in the electrical characteristics of a silicon wafer or the like that would otherwise be caused by metals and metalloids, other than silicon, contaminating the silicon wafer surface or diffusing into the inner part of the object to be polished. Furthermore, because silicon and silica are similar in terms of hardness, it is possible to carry out a polishing procedure without causing excessive damage to the silicon wafer surface. Specific examples of silica particles include colloidal silica, fumed silica and precipitated silica. From the viewpoint of preventing scratches on the surface of an object to be polished and being able to achieve a surface with a lower haze value, colloidal silica and fumed silica can be given as preferred examples of silica particles. Of these, colloidal silica is preferable.

In the art disclosed herein, the abrasive contained in the polishing composition may be in the form of primary particles or in the form of secondary particles formed by aggregation of a plurality of primary particles. The abrasives of the form of primary particles and of the form of secondary particles may be mixed. In a preferred embodiment, the polishing composition contains at least some of the abrasives in the form of secondary particles.

The average primary particle diameter of the abrasive (typically silica particles) is not particularly limited, but is preferably 5 nm or more, more preferably 10 nm or more, and particularly preferably 20 nm or more, from the viewpoint of polishing removal rate and the like. From the viewpoint of being able to achieve a higher polishing removal effect, the average primary particle diameter is preferably 25 nm or more, and even more preferably 30 nm or more. An abrasive having an average primary particle diameter of 40 nm or more may be used. In addition, the average primary particle diameter of the abrasive is preferably 200 nm or less, and more preferably 150 nm or less, for example 100 nm or less, from the viewpoint of reducing the amount of edge roll-off after polishing and the like.

In the present specification, the average primary particle diameter refers to a particle size (BET particle size) that is calculated from the specific surface area (BET value) measured by a BET method on the basis of the formula: average primary particle diameter (nm) = 6000/(true density (g/cm³) × BET value (m²/g)). The specific surface area can be measured, for example, by using a surface area measuring device, trade name "Flow Sorb II 2300" manufactured by Micromeritex Co., Ltd.

The average secondary particle diameter of the abrasive (for example, silica particles) is not particularly limited, but is preferably 15 nm or more, and more preferably 30 nm or more, from the viewpoint of polishing removal rate or the like. From the viewpoint of achieving a higher polishing removal effect, the average secondary particle diameter is preferably 50 nm or more. In addition, the average secondary particle diameter of the abrasive is appropriate to be 300 nm or less, preferably 260 nm or less, and more preferably 220 nm or less from the viewpoint of reducing the amount of edge roll-off after polishing and the like.

In the present specification, the average secondary particle size refers to a particle diameter (volume average particle size) measured by a dynamic light scattering method. The average secondary particle diameter of the abrasive can be measured, for example, using the model "FPAR-1000" manufactured by Otsuka Electronics Co., Ltd. or its equivalent.

The shape (contour) of the abrasive may be spherical or non-spherical. Specific examples of the non-spherical shape of the abrasive include a peanut shape (i.e., a peanut shell shape), a cocoon shape, a conpeito shape, a rugby-ball shape, etc.

Although not particularly limited, the average value of the long/short diameter ratio of the primary particles of the abrasive (average aspect ratio) is preferably 1.05 or more, and more preferably 1.1 or more. Increasing the average aspect ratio of the abrasive can achieve higher polishing removal rate. From the viewpoint of scratch reduction or the like, the average aspect ratio of the abrasive is preferably 3.0 or less, and more preferably 2.0 or less. In some embodiments, the average aspect ratio of the abrasive may be, for example, 1.5 or less, 1.4 or less, or 1.3 or less.

The shape (contour) and average aspect ratio of the abrasive can be grasped by, for example, observation with an electron microscope. A specific procedure for grasping the average aspect ratio includes, for example, drawing a minimum rectangle circumscribing each particle image of a predetermined number (for example, 200 particles) of abrasive particles, each independently having the shape that can be recognized with a scanning electron microscope (SEM), for example. Then, for the rectangle drawn along each particle image, a value obtained by dividing the length of the long side (long diameter value) by the length of the short side (short diameter value) is calculated as the long/short diameter ratio (aspect ratio). The average aspect ratio can be determined by arithmetically averaging the aspect ratios of the above predetermined number of particles.

The abrasive content in the polishing composition is not particularly limited, but is typically 0.01% by weight or more, preferably 0.03% by weight or more, more preferably 0.05% by weight or more, and even more preferably 0.1% by weight or more. Increasing the abrasive content can achieve higher polishing removal rate. From the viewpoint of reducing the amount of edge roll-off after polishing or the like, the abrasive content is usually appropriate to be 10% by weight or less, and it may be preferably 5% by weight or less, and more preferably 3% by weight or less. It may be 2% by weight or less, or 1.5% by weight or less (for example, 1.3% by weight or less), and can be further preferably 1% by weight or less (less than 1% by weight), for example, 0.8% by weight or less, or 0.5% by weight or less.

### <Surfactant>

The polishing composition disclosed herein contains, as the surfactant, a surfactant I having a repeating structure of oxyalkylene units (i.e., polyoxyalkylene chains, hereinafter also referred to as a "POA chain").

Examples of the above oxyalkylene units include an oxyethylene unit, an oxypropylene unit, and an oxybutylene unit. Such oxyalkylene units each can be, but are not limited to, repeating units derived from the respective alkylene oxides. The oxyalkylene units included in the POA chain of the surfactant I may be of one kind or two or more kinds. In a POA chain including two or more kinds of oxyalkylene units, the content of these oxyalkylene units in the POA chain is not particularly limited. In the POA chain including two or more kinds of oxyalkylene units, those oxyalkylene units may be composed of a random copolymer, block copolymer, alternating copolymer, or graft copolymer of the corresponding alkylene oxide. The surfactants I may be used alone or in combination of two or more kinds.

Specific examples of the surfactant I include: polyoxyalkylene alkyl ethers (e.g., polyoxyethylene alkyl ethers, polyoxypropylene alkyl ethers, polyoxyethylene polyoxypropylene alkyl ethers, polyoxyethylene polyoxybutylene alkyl ethers); polyoxyalkylene alkenyl ethers (e.g., polyoxyethylene oleyl ether); polyoxyalkylene phenyl ethers (e.g., polyoxyethylene phenyl ether; polyoxyethylene styrenated phenyl ether; and polyoxyalkylene alkyl phenyl ethers such as polyoxyethylene octyl phenyl ether, polyoxyethylene nonyl phenyl ether, and polyoxyethylene dodecyl phenyl ether); polyoxyalkylene alkylamines (e.g., polyoxyethylene laurylamine, polyoxyethylene stearylamine, polyoxyethylene oleylamine); polyoxyalkylene fatty acid esters (monoesters and diesters of saturated or unsaturated fatty acids such as polyoxyethylene monolaurate, polyoxyethylene monostearate, polyoxyethylene monooleate, polyoxyethylene distearate, and polyoxyethylene dioleate); polyoxyalkylene sorbitan fatty acid esters (e.g., polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate); fatty acid polyoxyalkylene sorbites (e.g., polyoxyethylene sorbitol tetraoleate); a block copolymer of ethylene oxide (EO) and propylene oxide (PO) (e.g., a diblock copolymer, a PEO (polyethylene oxide)-PPO (polypropylene oxide)-PEO type triblock, a PPO-PEO-PPO triblock copolymer, etc.); a random copolymer of EO and PO; and the other polymers such as polyoxyethylene glycol, polyoxyethylene castor oil, and polyoxyethylene hardened castor oil. In some embodiments, polyoxyalkylene alkyl ethers can be preferably used as the surfactant I.

The number of oxyalkylene units included in the surfactant I, i.e., the number of moles of an alkylene oxide added, can be selected so as to appropriately exhibit the effect of the use of the surfactant I. The upper limit of the number of moles of the alkylene oxide added is not particularly limited, but it is, for example, 100 or less and appropriate to be 80 or less. From the viewpoint of suppressing the reduction in the polishing removal rate, it is preferably 60 or less, more preferably 40 or less, and even more preferably 30 or less, and may be 25 or less, or 18 or less (for example, 14 or less). The lower limit of the number of moles of the alkylene oxide added is not particularly limited, but it is, for example, 3 or more and appropriate to be 5 or more. It is preferably 7 or more (for example, 9 or more), and may be 10 or more, 12 or more, or 15 or more (for example, 20 or more).

In some embodiments, the surfactant I having a POA chain including at least oxyethylene units can be preferably adopted from the viewpoint of suitably exhibiting the effects of suppressing the reduction in the polishing removal rate and reducing the amount of edge roll-off. The proportion of the number of oxyethylene units (EO number) in the total number of oxyalkylene units included in the surfactant I may be, for example, 1% or more, and is preferably 5% or more, and more preferably 10% or more. It may be 20% or more, 30% or more, 45% or more, or 55% or more. Oxyethylene units may make up 100% of the oxyalkylene units included in the surfactant I. When the surfactant I includes a combination of oxyethylene and oxypropylene units, the ratio of the number of oxypropylene units (PO number) to the number of oxyethylene units (EO number) (PO/EO) may be, for example, 5.0 or less and is preferably 3.0 or less, and more preferably 2.0 or less. In some embodiments, the above ratio (PO/EO) may be, for example, 1.5 or less, 1.0 or less, or 0.8 or less. The ratio (PO/EO) may be, for example, 0.1 or more, 0.2 or more, 0.4 or more, 0.6 or more, 0.9 or more, or 1.3 or more.

When a polyoxyalkylene alkyl ether is used as the surfactant I, the number of carbons of the alkyl group in the alkyl ether is not particularly limited and can be selected so as to appropriately exhibit the effect of the use of the surfactant I. From the viewpoint of easily exhibiting surfactant ability, the number of carbons of the alkyl group is appropriate to be 3 or more, and it is preferably 5 or more. From the viewpoint of surface protection and the like of an object to be polished, the number of carbons of the alkyl group is preferably 7 or more, and more preferably 8 or more, and it may be 10 or more, or 12 or more. The number of carbons of the alkyl group may be, for example, 27 or less, 25 or less, or 20 or less. From the viewpoint of solubility and the like of the surfactant I, in some embodiments, the number of carbons of the alkyl group is preferably 18 or less, more preferably 16 or less, and even more preferably 14 or less. The alkyl group may be either straight or branched. Specific examples of alkyl groups in the alkyl ethers include, but are not limited to, propyl, butyl, pentyl, hexyl, octyl, 2-ethylhexyl, nonyl, decyl, isodecyl, lauryl, tridecyl, cetyl, stearyl, and isostearyl groups.

As the polyoxyalkylene alkyl ether, one in which the primary carbon of the alkyl group is ether-bonded to a polyoxyalkylene (hereinafter also referred to as a "polyoxyalkylene primary alkyl ether"), or one in which the secondary carbon of the alkyl group is ether-bonded to a polyoxyalkylene (hereinafter also referred to as a "polyoxyalkylene secondary alkyl ether") can be preferably used. In the polyoxyalkylene primary alkyl ether, the alkyl group may be either straight or branched. In the polyoxyalkylene secondary alkyl ether, the two alkyl groups bonded to the secondary carbon may be the same or different from each other. The two alkyl groups bonded to the secondary carbon may be independently straight or branched.

In the polishing composition disclosed herein, a weight average molecular weight (Mw) of the surfactant I is not particularly limited and can be selected as needed to the extent that the effect of the present invention is appropriately exhibited. From the viewpoint of suppressing the reduction in the polishing removal rate, in some embodiments, the Mw of the surfactant I is appropriate to be less than 4000, and it is preferably 3000 or less, more preferably 2500 or less, and even more preferably 2000 or less, and may be 1500 or less. The Mw of the surfactant I is appropriate to be 200 or more from the viewpoint of surfactant ability and the like, and is preferably 300 or more (e.g., 350 or more) from the viewpoint of reducing edge roll-off after polishing. In some embodiments, the Mw of surfactant I may be 400 or more, 500 or more, 600 or more, or 800 or more (e.g., 1000 or more).

The molecular weight calculated from the chemical formula is adopted as the Mw of the surfactant I.

The content of the surfactant I in the polishing composition is not particularly limited as long as it does not significantly interfere with the effect of the present invention. The content of the surfactant I can be, for example, 1.0×10⁻⁶ % by weight or more. From the viewpoint of reducing the amount of edge roll-off, it is appropriate to be 5.0×10⁻⁶ % by weight or more, and is preferably 1.0×10⁻⁵ % by weight or more, more preferably 5.0×10⁻⁵ % by weight or more, and even more preferably 1.0×10⁻⁴ % by weight or more by weight. The content of the surfactant I can be, for example, 0.5% by weight or less, and from the viewpoint of maintaining the polishing removal rate, it is appropriate to be 0.25% by weight or less, and it is preferably 0.1% by weight or less, and more preferably 0.05% by weight or less, and may be 0.01% by weight or less. Note that when the polishing composition disclosed herein contains two or more kinds of surfactants I, the above content refers to the total content of those surfactants I. The above-mentioned content of the surfactant I can be preferably adopted in a mode in which the polishing composition is used in the form of a polishing slurry.

The ratio (A/S) of the content (A) of the abrasives by weight to the content (S) of the surfactant I by weight in the polishing composition is not particularly limited as long as it does not significantly interfere with the effect of the art disclosed herein. The A/S ratio is typically 100 or more, preferably 200 or more, more preferably 300 or more, and even more preferably 400 or more. By increasing the above A/S ratio, the reduction in edge roll-off after polishing can be suitably achieved while maintaining the polishing removal rate. The A/S ratio may be, for example, 10000 or less, 7500 or less, 5000 or less, 3000 or less, or 2000 or less, and can be preferably 1500 or less (for example, 1300 or less), more preferably 1000 or less (for example, less than 1000), or 800 or less.

The polishing composition disclosed herein may further contain one or two or more kinds of surfactants that do not correspond to the surfactant I as an optional component to the extent that the effect of the present invention is not significantly impaired. The above optional surfactants that do not correspond to the surfactant I may be anionic, cationic, nonionic, or amphoteric. The Mw of the optional surfactant can be selected as appropriate from the same range as the surfactant I. The Mw of the optional surfactant is calculated based on the chemical formula in the same way as the Mw of the surfactant I. The content of the optional surfactant can be, for example, 20 parts by weight or less, less than 10 parts by weight, less than 3 parts by weight, less than 1 part by weight, or less than 0.3 parts by weight (e.g., less than 0.1 parts by weight) with respect to 100 parts by weight of the abrasives. Preferably, the content of the optional surfactant is, for example, less than 1, less than 0.5, or less than 0.1 times the content of the surfactant I on the weight basis. The polishing composition disclosed herein can be suitably implemented without containing such an optional surfactant.

### <Basic Compound>

The polishing composition disclosed herein contains a basic compound. Here, the term "basic compound" refers to a compound having the function of increasing the pH of the polishing composition when added to the polishing composition. The basic compound may be an organic basic compound or an inorganic basic compound. These basic compounds can be used alone or in combination with two or more kinds.

Examples of organic basic compounds include quaternary ammonium salts such as tetraalkylammonium salts. Anions in such ammonium salts can be, for example, OH⁻, F⁻, Cl⁻, Br⁻, I⁻, ClO₄⁻ ; BH₄⁻, HCO₃⁻, etc. For example, quaternary ammonium salts such as choline, tetramethylammonium hydroxide, tetraethylammonium hydroxide, tetrapropylammonium hydroxide, tetrabutylammonium hydroxide, and tetramethylammonium bicarbonate can be suitably used. Of these, tetramethylammonium hydroxide is preferable. Other examples of organic basic compounds include quaternary phosphonium salts such as tetraalkylphosphonium salts. Anions in such phosphonium salts can be, for example, OH⁻, F⁻, Cl⁻, Br⁻, I⁻, ClO₄⁻, BH4⁻, HCO₃⁻, etc. For example, halides and hydroxides of tetramethylphosphonium, tetraethylphosphonium, tetrapropylphosphonium and tetrabutylphosphonium can be suitably used. Other examples of organic basic compounds include amines such as methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine and triethylenetetramine; piperazine compounds such as 1-(2-aminoethyl)piperazine and N-methylpiperazine; azole compounds such as imidazole and triazole; and guanidine.

Examples of inorganic basic compounds include ammonia; hydroxides of ammonia, alkali metals and alkaline earth metals; carbonates of ammonia, alkali metals and alkaline earth metals; and bicarbonates of ammonia, alkali metals and alkaline earth metals. Specific examples of such hydroxides include potassium hydroxide and sodium hydroxide. Specific examples of such carbonates and bicarbonates include ammonium bicarbonate, ammonium carbonate, potassium bicarbonate, potassium carbonate, sodium bicarbonate, and sodium carbonate.

Preferred basic compounds include ammonia, potassium hydroxide, sodium hydroxide, tetramethylammonium hydroxide, tetraethylammonium hydroxide, ammonium bicarbonate, ammonium carbonate, potassium bicarbonate, potassium carbonate, sodium bicarbonate and sodium carbonate. Of these, ammonia, potassium hydroxide, sodium hydroxide, tetramethylammonium hydroxide, and potassium carbonate are preferable. Of these, tetramethylammonium hydroxide and potassium carbonate are more preferable.

The basic compound content in the polishing composition is usually appropriate to be 0.001% by weight or more. From the viewpoint of polishing removal rate or the like, the content is preferably 0.005% by weight or more, more preferably 0.01% by weight or more, and even more preferably 0.03% by weight or more. From the viewpoint of achieving the polishing removal rate and the reduction in the edge roll-off, both at high levels, the base compound content is usually appropriate to be 1% by weight or less, and preferably 0.5% by weight or less, and more preferably 0.3% by weight or less. In the polishing composition used as the polishing slurry as it is, the content may be, for example, 0.5% by weight or less, 0.2% by weight or less, or 0.1% by weight or less.

The ratio (B/S) of the content (B) of the basic compound by weight to the content (S) of the surfactant I by weight in the polishing composition is not particularly limited as long as it does not significantly interfere with the effect of the art disclosed herein. The B/S ratio is typically 50 or more, preferably 70 or more, and more preferably 90 or more, and may be 100 or more, or 115 or more. Increasing the B/S ratio can suitably achieve the effect of reducing the edge roll-off after polishing while maintaining the polishing removal rate. The B/S ratio can be, for example, 300 or less, and it is preferably 250 or less, and more preferably 200 or less, and may be 170 or less, or 140 or less.

### <Chelating Agent>

The polishing composition disclosed herein contains a chelating agent. The chelating agent forms complex ions with metal impurities that may be present in the polishing composition, and thereby traps these metal impurities. As a result, the chelating agent has the function of suppressing the contamination of an object to be polished by metal impurities. The chelating agents can be used alone or in combination of two or more kinds. Examples of chelating agents include aminocarboxylic acid-based chelating agents, organic phosphonic acid-based chelating agents and organic sulfonic acid-based chelating agents. Examples of aminocarboxylic acid-based chelating agents include ethylenediamine tetraacetic acid, sodium ethylenediamine tetraacetate, nitrilotriacetic acid, sodium nitrilotriacetate, ammonium nitrilotriacetate, hydroxyethylethylenediamine triacetic acid, sodium hydroxyethylethylenediamine triacetate, diethylenetriamine pentaacetic acid, sodium diethylenetriamine pentaacetate, triethylenetetramine hexaacetic acid, and sodium triethylenetetramine hexaacetate. Examples of organic phosphonic acid-based chelating agents include 2-aminoethylphosphonic acid, 1-hydroxyethylidene-1,1-diphosphonic acid, aminotri(methylenephosphonic acid), ethylenediamine tetrakis(methylenephosphonic acid), diethylenetriamine-penta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid and α-methylphosphonosuccinic acid. Examples of organic sulfonic acid-based chelating agents include ethylenediamine tetrakis(methylenesulfonic acid). Of these, organic phosphonic acid-based chelating agents and organic sulfonic acid-based chelating agents are more preferable, and of these, ethylenediamine tetrakis(methylenephosphonic acid) is particularly preferable.

The chelating agent content in the polishing composition is usually appropriate to be 0.0001% by weight or more. The content is preferably 0.0005% by weight or more, and more preferably 0.001% by weight or more. The chelating agent content is usually appropriate to be 0.05% by weight or less and is preferably 0.01% by weight or less, more preferably 0.008% by weight or less, and even more preferably 0.005% by weight or less.

### <Water>

The polishing composition disclosed herein contains water. Ion exchanged water (deionized water), pure water, ultrapure water, distilled water, and the like can be suitably used as the water. In order for the functions of other components contained in the polishing composition to be impaired as little as possible, the water used preferably has a total content of, for example, transition metal ions of 100 ppb or less. For example, it is possible to increase the purity of the water by removing impurity ions by means of an ion exchange resin, removing contaminants by means of filtration, or carrying out a procedure such as distillation.

### <Preparation of polishing composition>

A method for producing the polishing composition disclosed herein is not particularly limited. For example, the respective components contained in the polishing composition should be mixed using, for example, a well-known mixing apparatus such as a blade type stirrer, an ultrasonic disperser or a homomixer. The manner in which these components are mixed is not particularly limited. For example, it is possible to mix all of the components at once or mix the components in an appropriately specified order.

The polishing composition disclosed herein may be a single-agent type or a multi-agent type such as a two-agent type. For example, a part A, which contains some of the constituent components of the polishing composition, and a part B, which contains the remaining components of the composition, may be mixed and used for polishing an object to be polished.

### <Polishing slurry>

The polishing composition disclosed herein is typically supplied to an object to be polished in the form of a polishing slurry that contains the polishing composition. In addition, the polishing composition is used in the form of a polishing slurry to polish an object to be polished. The polishing slurry can be prepared, for example, by diluting any of the polishing compositions disclosed herein. Here, dilution is typically dilution with water. Alternatively, the polishing composition may be used as-is as a polishing slurry. Other examples of the polishing slurry that contains the polishing composition disclosed herein include polishing slurries obtained by adjusting the pH of the composition.

The pH of the polishing slurry is 8.0 or higher, and is, for example, preferably 8.5 or higher, more preferably 9.0 or higher, even more preferably 9.5 or higher, and particularly preferably 10.0 or higher, for example 10.5 or higher. As the pH of the polishing slurry becomes higher, the polishing removal rate tends to improve. The upper limit of the pH of the polishing slurry is not particularly limited, but is 12.0 or lower, and is, for example, preferably 11.8 or lower, and more preferably 11.5 or lower.

### <Concentrate>

The polishing composition disclosed herein may be in a concentrated form before being supplied to an object to be polished. A polishing composition that has been concentrated is advantageous in terms of convenience, cost reduction, etc., during manufacture, distribution, storage and the like. The concentration factor is not particularly limited and can be, for example, approximately 2- to 80-fold by volume and preferably approximately 5- to 60-fold by volume, and it may be approximately 15- to 40-fold or 25- to 40-fold by volume.

The polishing composition in such a form of the concentrate can be used in an embodiment in which the composition is diluted when needed to prepare a polishing slurry and the polishing slurry is then supplied to an object to be polished. Typically, this dilution can be carried out by adding water to the concentrate and mixing. In addition, in a multi-agent type polishing composition, such as that described below, it is possible to prepare a polishing slurry by diluting some of these components and then mixing them with the remaining components, or by mixing the multiple components and then diluting this mixture.

The abrasive content in the concentrate can be, for example, 50% by weight or less. From the viewpoint of stability, filtration properties and the like of the polishing composition, the content is usually preferably 45% by weight or less, and more preferably 40% by weight or less. Here, an example of the stability of the polishing composition is dispersion stability of the abrasive. In addition, from the viewpoint of convenience, cost reduction and the like during manufacture, distribution, storage, etc., the abrasive content can be, for example, 1.0% by weight or more, and is preferably 3.0% by weight or more, more preferably 5.0% by weight or more, and even more preferably 7.0% by weight or more.

The content of the surfactant I in the concentrate may be, for example, 0.0001% by weight or more, and is preferably 0.001% by weight or more, more preferably 0.005% by weight or more, and even more preferably 0.01% by weight or more. The content of the surfactant I is usually appropriate to be 1% by weight or less, and it is preferably 0.5% by weight or less, and may be 0.1% by weight or less, 0.05% by weight or less, or 0.03% by weight or less.

The basic compound content in the concentrate is usually appropriate to be 0.03% by weight or more. The content is preferably 0.15% by weight or more, more preferably 0.3% by weight or more, and even more preferably 1% by weight or more. In addition, the basic compound content is usually appropriate to be 15% by weight or less, and it is preferably 10% by weight or less and more preferably 6% by weight or less, and may be 4% by weight or less, or 3% by weight or less.

The chelating agent content in the concentrate is usually appropriate to be 0.003% by weight or more. The content is preferably 0.005% by weight or more, more preferably 0.01% by weight or more, even more preferably 0.03% by weight or more, and particularly preferably 0.05% by weight or more. Further, the chelating agent content is usually appropriate to be 1.5% by weight or less, and is preferably 1% by weight or less, more preferably 0.5% by weight or less, even more preferably 0.3% by weight or less, and particularly preferably 0.1% by weight or less.

### <Applications>

The polishing composition disclosed herein can be preferably used to polish an object to be polished having a surface made of silicon. The art disclosed herein may be particularly applicable, for example, to a polishing composition containing silica particles as the abrasive and where the object to be polished is made of silicon. Typically, the polishing composition contains only silica particles as the abrasive. The shape of the object to be polished is not particularly limited. The polishing composition disclosed herein can be suitably used to polish an object to be polished having a plane with, for example, a plate shape or a polyhedral shape, or an edge of the object to be polished. For example, the polishing composition can be suitably used to polish a wafer edge.

### <Polishing method>

The polishing composition disclosed herein is used as a polishing composition for performing stock polishing of a silicon wafer in polishing monocrystalline or polycrystalline silicon wafers as objects to be polished. The silicon wafer typically has a surface made of silicon. Atypical example of the silicon wafer is a monocrystalline silicon wafer, and is, for example, a monocrystalline silicon wafer obtained by slicing a monocrystalline silicon ingot. A description will now be given of a preferred embodiment of a method for polishing an object to be polished using the polishing composition disclosed herein. That is, a polishing liquid (slurry) containing any of the polishing compositions disclosed herein is prepared. The preparation of the polishing slurry can include additionally performing an operation to the polishing composition, such as adjustment of the concentration of the polishing composition, to prepare the polishing slurry. Here, an example of the concentration adjustment is dilution. Alternatively, the polishing composition may be used as-is as a polishing slurry. In addition, in the case of a multi-agent type polishing composition, the preparation of the polishing slurry can include mixing these components, diluting one or more of the components prior to mixing, and diluting the obtained mixture after the mixing.

Next, this polishing slurry is supplied to an object to be polished, and polishing is carried out using a conventional method. For example, in the case where an object to be polished is subjected to a primary polishing step (a first stock polishing step), the object to be polished subjected to a lapping step is then placed in a general polishing machine. In the primary polishing step, both the surfaces of the object to be polished are typically polished. The polishing slurry is supplied to a surface of the object to be polished via a polishing pad in the polishing machine. Typically, while the polishing slurry is continuously supplied, the polishing pad is pushed against the surface of the object to be polished, and both the polishing pad and the object to be polished are moved against each other (for example, moved in circular motion). Thereafter, the object to be polished is further subj ected to a secondary polishing step (a second stock polishing step) as needed, finally followed by a final polishing step, whereby the polishing of the object to be polished is completed. In the secondary polishing step, one surface of the object to be polished is typically polished. Moreover, the polishing pad used in the polishing step in which the polishing composition disclosed herein is used is not particularly limited. For example, it is possible to use any one of a non-woven fabric polishing pad, a suede type polishing pad, a polyurethane type polishing pad, a polishing pad that contains abrasive, a polishing pad that does not contain abrasive, and the like.

The present specification provides a method for producing a polished article, the method including a step of polishing an object to be polished using the polishing composition disclosed herein. The method for producing a polished article disclosed herein may also include a step of subjecting an object to be polished, which has been polished using the polishing composition, to final polishing. Here, the term "final polishing" means a final polishing step in the process for producing the target product, that is, a step after which no further polishing is carried out. This final polishing step may be carried out using the polishing composition disclosed herein or using another polishing composition. In a preferred embodiment, a polishing step in which the polishing composition is used is a polishing step that is carried out prior to the final polishing. Of these, the polishing composition can be suitably used in the stock polishing step following the completion of a lapping step. For example, the polishing composition can be suitably used in a step of polishing both surfaces of an object to be polished after a lapping step (typically a primary polishing step) or in an initial step of polishing one surface of a substrate (typically an initial secondary polishing step), both surfaces of which have been polished. In the above-mentioned step in which both surfaces are polished and the above-mentioned initial step in which one surface is polished, the required polishing removal rate is greater than in the final polishing. Therefore, the polishing composition disclosed herein is suitable for use as a polishing composition used for polishing an object to be polished in at least one of the step in which both surfaces of the object to be polished are polished and the initial step in which one surface of the object to be polished is polished (and preferably both of these steps).

Moreover, the polishing composition may be used in a way that the composition is used for polishing and then disposed (so-called "one-way"), but may also be recycled. One example of a method of recycling the polishing composition is a method where a tank collects a used portion of the polishing composition released from a polishing machine and supplies the collected polishing composition back to the polishing machine. In the case where the polishing composition is recycled, it is possible to reduce the burden on the environment by reducing the amount of spent polishing composition treated as waste liquid, compared to the case where the polishing composition is used in one-way. In addition, it is possible to reduce costs by reducing the amount of the polishing composition used. In the case where the polishing composition disclosed herein is recycled, it is possible to add fresh components or components that have been depleted through use to the polishing composition during use at an appropriate time.

### [Examples]

Several examples relating to the present invention will now be explained, but the present invention is not intended to be limited to these examples. Moreover, in the following description, "%" is on the weight basis, unless otherwise indicated.

### <Preparation of polishing composition>

### (Examples 1 to 8)

A concentrate of a polishing composition was prepared by mixing an abrasive, a surfactant, a basic compound, a chelating agent, and deionized water. Silica particles (having an average primary particle diameter of 55 nm) were used as the abrasive. As the surfactant, surfactants A to H, which were polyoxyalkylene alkyl ethers having the structures shown in Table 1, were used. Note that in Table 1, the "EO number" indicates the number of moles of ethylene oxide added, the "PO number" indicates the number of moles of propylene oxide added, the "PO/EO ratio" indicates the ratio of the number of moles of propylene oxide added to the number of moles of ethylene oxide added, and the "carbon number" indicates the number of carbons in the alkyl group. In the "carbon chain" column, one in which the primary carbon of the alkyl group is ether-bonded to a polyoxyalkylene is labeled as "straight", and one in which the secondary carbon of the alkyl group is ether-bonded to a polyoxyalkylene is labeled as "branched". The molecular weights of the surfactants A to H are as shown in the "molecular weight" column of Table 1. As the basic compounds, tetramethylammonium hydroxide (hereinafter referred to as "TMAH") and potassium carbonate (hereinafter referred to as "K₂CO₃") were used. Ethylenediamine tetrakis(methylenephosphonic acid) (hereinafter referred to as "EDTPO") was used as the chelating agent. The abrasive content in the concentrate of the polishing composition was 8.0%, the surfactant content in the concentrate was 0.018%, the TMAH content in the concentrate was 1.6%, the K₂CO₃ content in the concentrate was 0.6%, and the EDTPO content in the concentrate was 0.04%.

### (Comparative Example 1)

Instead of the surfactant A, polyvinylpyrrolidone (hereinafter referred to as "PVP") having a Mw of 1.7×10⁴ was used. The PVP content in the concentrate of the polishing composition was 0.036%. In other respects, the polishing composition of the present example was prepared in the same way as in Example 1. The names and molecular weights of the polymers used are described in the surfactant column for convenience.

### <Evaluation of polishing removal rate of silicon >

In each example, a polishing slurry obtained by diluting a concentrate of the polishing composition of the example by 30 times with water was used, and a polishing test was performed on a silicon wafer, whereby the polishing removal rate of silicon and amount of edge roll-off were evaluated. A monocrystalline silicon wafer (conduction type: P-type, crystal orientation: <100>, resistivity: 1 Ω·cm or more and less than 100 Ω·cm) of 300 mm in diameter, subjected to lapping and etching, was used as the object to be polished. This object to be polished was polished under the following conditions. The average thickness thereof before and after the polishing were measured by "Nano Metro 300-TT" manufactured by Kuroda Precision Industries Ltd. The measurement was performed across the entire surface of the silicon wafer except for a peripheral area that is within 1 mm from the outer peripheral edge of the silicon wafer. The measurement pitch was 1 mm. The polishing removal rate was then calculated from a difference between thickness averages before and after the polishing and the polishing time. The obtained value was converted to a relative value, assuming that the value of Comparative Example 1 was 100%. The converted values are shown in the "polishing removal rate" column of Table 1. If the "polishing removal rate" is 70% or higher, it is determined that the maintenance of the polishing removal rate was achieved.

### [Polishing conditions]

Polishing machine: model"20B-5P-4D", a double-sided polishing machine manufactured by SpeedFam Company Limited.
Polishing pad: trade name "MH S-15A" manufactured by Nitta Haas Incorporated Polishing load: 4935 N
Upper platen rotational speed: -21 rpm (clockwise being defined as the forward rotation, with the same going for the following)
Lower platen rotational speed: +35 rpm
Sun gear rotational speed: + 16.2 rpm
Internal gear rotational speed: +4.5 rpm
Polishing removal: 3 µm
Flow rate of polishing slurry: 4.5 L/min (used in one-way)
Polishing slurry temperature: 25°C

### <Evaluation of amount of edge roll-off>

The amount of edge roll-off at the outer peripheral portion of the silicon wafer obtained after the polishing was evaluated. The amount of edge roll-off was evaluated by measuring a shape displacement amount of the surface of the silicon wafer using "Nano Metro 300-TT" manufactured by Kuroda Precision Industries Ltd. Specifically, a comparatively flat region that covers an area between 3.0 mm and 6.0 mm from the outer peripheral edge of the silicon wafer towards its center was used as a reference region, and a straight line (reference straight line) that approximates the shape displacement amount in this region was drawn using the least-squares method. Next, a distance between the above reference straight line and the shape displacement amount of a part of the silicon wafer located at a distance of 1.0 mm from the outer peripheral edge of the wafer was measured, and this measured value was defined as a roll-off value of the silicon wafer. The obtained value was converted to a relative value assuming that the value of Comparative Example 1 was 100%, and the converted values are shown in the "RoA" (roll-off amount) column of Table 1. It is determined that as the "RoA" value became smaller, the amount of edge roll-off was more effectively reduced.

**[Table 1]**

| Table 1 | | | | | | | | | |
|---|---|---|---|---|---|---|---|---|---|
| | SURFACTANT | | | | | | | POLISHING REMOVAL RATE | RoA |
| | KIND | MOLECULAR WEIGHT | CARBON NUMBER | EO NUMBER | PO NUMBER | PO/EO RATIO | CARBON CHAIN | | |
| EXAMPLE 1 | A | 1400 | 10 | 9 | 15 | 1.67 | BRANCHED | 104% | 59% |
| EXAMPLE 2 | B | 960 | 13 | 9 | 6 | 0.67 | STRAIGHT | 83% | 67% |
| EXAMPLE 3 | C | 820 | 13 | 6 | 7 | 1.17 | STRAIGHT | 93% | 72% |
| EXAMPLE 4 | D | 770 | 13 | 10 | 3 | 0.30 | STRAIGHT | 80% | 78% |
| EXAMPLE 5 | E | 378 | 10 | 5 | 0 | 0 | STRAIGHT | 92% | 80% |
| EXAMPLE 6 | F | 582 | 10 | 10 | 0 | 0 | STRAIGHT | 78% | 81% |
| EXAMPLE 7 | G | 830 | 10 | 9 | 5 | 0.56 | BRANCHED | 83% | 84% |
| EXAMPLE 8 | H | 720 | 10 | 7 | 4.5 | 0.64 | BRANCHED | 103% | 98% |
| COMPARATIVE EXAMPLE 1 | PVP | 17000 | - | - | - | - | - | 100% | 100% |

As shown in Table 1, it was confirmed that the polishing compositions of Examples 1 to 8 containing the surfactants A to H were able to exhibit a higher effect of reducing the edge roll-off while maintaining a suitable polishing removal rate. As can be seen from the above results, the amount of edge roll-off after the polishing can be effectively reduced while maintaining the polishing removal rate by the inclusion of the surfactant having a repeating structure of oxyalkylene units, in addition to the abrasives, the basic compound, the chelating agent, and water.

While specific examples of the present invention have been described above in detail, these are illustrative only, and do not limit the scope of the claims. The art recited in the claims include various modifications and alternations of the specific examples exemplified above.

## Claims

1. A polishing composition to be used for stock polishing of a silicon wafer, consisting of an abrasive, a basic compound, a surfactant, a chelating agent, and water, wherein
the surfactant contains a surfactant I having a repeating structure of oxyalkylene units.

2. The polishing composition according to claim 1, wherein the surfactant I is a polyoxyalkylene alkyl ether.

3. The polishing composition according to claim 1 or 2, wherein a ratio (B/S) of a content (B) of the basic compound by weight to a content (S) of the surfactant I by weight is 50 or more.

4. The polishing composition according to any one of claims 1 to 3, wherein a ratio (A/S) of a content (A) of the abrasive by weight to a content (S) of the surfactant I by weight is less than 1000.

5. The polishing composition according to any one of claims 1 to 4, wherein the abrasive contains silica particles.

6. A concentrate for the polishing composition according to any one of claims 1 to 5.
